# EUROPÄISCHE PATENTSCHRIFT

(11) **EP 1 623 056 B1**
(45) Veröffentlichungstag und Bekanntmachung des Hinweises auf die Patenterteilung: **15.07.2009**
(21) Anmeldenummer: 04732981.8
(22) Anmeldetag: 14.05.2004
(51) Int. Cl.: C25D 5/20

(54) **VERFAHREN UND VORRICHTUNG ZUR BESCHICHTUNG EINES SUBSTRATS**
METHOD AND DEVICE FOR COATING A SUBSTRATE
PROCEDE ET DISPOSITIF POUR APPLIQUER UN REVETEMENT SUR UN SUBSTRAT

(30) Priorität: 15.05.2003 DE 10323658
(43) Veröffentlichungstag der Anmeldung: 08.02.2006
(73) Patentinhaber: Gebr. Schmid GmbH & Co., D-72250 Freudenstadt (DE)
(72) Erfinder: SCHMID, Christian, 72250 Freudenstadt (DE)
(74) Vertreter: Patentanwälte Ruff, Wilhelm, Beier, Dauster & Partner
(86) Internationale Anmeldenummer: PCT/EP2004/005226
(87) Internationale Veröffentlichungsnummer: WO 2004/101863

(56) Entgegenhaltungen:
- EP-A- 0 103 505
- DE-A- 2 019 178
- US-A- 4 789 405
- US-A- 5 876 507
- US-A1- 2001 023 828
- PATENT ABSTRACTS OF JAPAN Bd. 0123, Nr. 65 (C-532), 29. September 1988 (1988-09-29) & JP 63 118094 A (SUMITOMO HEAVY IND LTD), 23. Mai 1988 (1988-05-23)

## Beschreibung

### Anwendungsgebiet und Stand der Technik

Die Erfindung betrifft ein Verfahren zur Beschichtung eines Substrats mit den Merkmalen des Oberbegriffs des Anspruchs 1 sowie eine Vorrichtung zur Beschichtung eines Substrats mit den Merkmalen des Oberbegriffs des Anspruchs 5. Insbesondere handelt es sich bei der Beschichtung des Substrats um eine Abscheidung von sogenanntem chemischem Kupfer auf einer Leiterplatte. Dabei kann Kupfer gelöst sein in einem flüssigen Elektrolyten als Behandlungsflüssigkeit. Die Substratoberfläche, insbesondere auch an Wandungen von Bohrungen oder Vertiefungen, kann mit ionischen oder metallischen Aktivatoren bedeckt sein, mittels derer sich eine dünne Schicht Kupfer auf der Substratoberfläche abscheidet.

Zur Abscheidung des Kupfers ist es erforderlich, dass der Elektrolyt mit dem darin gelösten Kupfer an die Oberfläche des Substrats heran gebracht wird. Hierzu wird konventionell eine sogenannte Schwalltechnik eingesetzt, mittels derer die Oberfläche benetzt wird mit dem Elektrolyt sowie Bohrungen oder Vertiefungen geflutet werden. Umso höher die Anforderungen an diese Beschichtung sind, insbesondere bei Substraten mit Bohrungen geringen Durchmessers, umso schwieriger ist eine gleichmäßige Beschichtung sicherzustellen.

Die DE 2019178 A offenbart ein Verfahren und eine Vorrichtung zur Beschichtung eines Substrats mit einem in einer Behandlungsflüssigkeit gelösten Material, wobei das Substrat zumindest teilweise mit der Behandlungsflüssigkeit in einem Bad benetzt wird, und das Bad mit der Behandlungsflüssigkeit und/oder das Substrat mit Schall beaufschlagt werden.

Die US 4789405 offenbart ein Verfahren und eine Vorrichtung zur Beschichtung eines flächigen Substrats, das horizontal in dem Bad liegt, mit einem in einer Behandlungsflüssigkeit gelösten Material, wobei das Substrat mit der Behandlungsflüssigkeit über einem Bad benetzt wird und mit Schall beaufschlagt wird.

Die JP 63118094 A offenbart ein Verfahren und eine Vorrichtung zur Beschichtung eines flächigen Substrats, das horizontal in dem Bad liegt, mit einem in einer Behandlungsflüssigkeit gelösten Material, wobei das Substrat mit der Behandlungsflüssigkeit in oder über einem Bad benetzt wird und das Bad mit der Behandlungsflüssigkeit und/oder das Substrat mit Schall beaufschlagt werden.

Die EP 103505 A offenbart ein Verfahren und eine Vorrichtung zur Beschichtung eines flächigen Substrats, das horizontal in dem Bad liegt, mit einem in einer Behandlungsflüssigkeit gelösten Material, wobei das Substrat mit der Behandlungsflüssigkeit in oder über einem Bad benetzt wird und das Bad mit der Behandlungsflüssigkeit und/oder das Substrat mit Schall beaufschlagt werden.

Die US 5876507 offenbart ein Verfahren und eine Vorrichtung zur Beschichtung eines flächigen Substrats mit einem in einer Behandlungsflüssigkeit gelösten Material, wobei das Substrat mit der Behandlungsflüssigkeit in einem Bad benetzt wird und das Bad mit der Behandlungsflüssigkeit und/oder das Substrat mit Schall beaufschlagt werden.

Die US 2001/023828 A offenbart ein Verfahren und eine Vorrichtung zur Beschichtung eines Substrats, das horizontal in dem Bad liegt, mit einem in einer Behandlungsflüssigkeit gelösten Material, wobei das Substrat mit der Behandlungsflüssigkeit in einem Bad benetzt wird und das Bad mit der Behandlungsflüssigkeit und/oder das Substrat mit Schall beaufschlagt werden.

### Aufgabe und Lösung

Der Erfindung liegt die Aufgabe zugrunde, ein eingangs genanntes Verfahren sowie eine eingangs genannte Vorrichtung zu schaffen, mit denen die Probleme des Standes der Technik vermieden werden können, insbesondere die Beschichtung von Substraten mit Bohrungen oder Vertiefungen vor allem in den Bohrungen oder Vertiefungen sichergestellt werden können.

Gelöst wird diese Aufgabe durch ein Verfahren mit den Merkmalen des Anspruchs 1. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht.

Der grundsätzliche Gedanke der Erfindung besteht darin, Schall zur Optimierung der Beschichtung einzusetzen. Hierzu werden das Bad mit Behandlungsflüssigkeit und/oder das Substrat selber mit Schall beaufschlagt. Dabei ist es möglich, Gasblasen aus dem Elektrolyt zu treiben und lokale Elektrolytströmungen an der Substratoberfläche zu erzeugen. Diese wiederum unterstützen die Abscheidung bzw. Beschichtung des Substrats mit dem Material. Dies gilt insbesondere für Substrate mit dünnen Bohrungen, beispielsweise Leiterplatten, in denen auch Micro-Via-Technik zum Einsatz kommen kann.

Vorteilhaft erfolgt eine Beaufschlagung mit Schall einer hohen Frequenz. Als besonders vorteilhaft haben sich hier Frequenzen über 10kHz, insbesondere zwischen 10kHz und 25kHz oder 30kHz, erwiesen. Sehr vorteilhaft kann Ultraschall eingesetzt werden.

Gemäß der Erfindung wird die Beschallung des Substrats und/oder des Bades mit der Behandlungsflüssigkeit indirekt vorgenommen. Hierzu wird der Schallgeber außerhalb des Bades angeordnet. Eine Ankopplung des Schalls in das Bad bzw. in die Behandlungsflüssigkeit oder an das Substrat erfolgt über Ankopplungsmittel. Diese weisen eine Kopplerflüssigkeit auf, welche den Schall von dem außerhalb angeordneten Schallgeber über eine in dem Bad bzw. in der Behandlungsflüssigkeit angeordneten Membran überträgt. Die Ankopplung mittels einer Kopplerflüssigkeit wird als besonders vorteilhaft angesehen, insbesondere zur möglichst verlustfreien Schallübertragung.

Des weiteren ist es möglich, eine Beschallung aus mehreren Richtungen vorzunehmen. Hierzu können mehrere Schallgeber vorgesehen sein. Auch hier ist es möglich, eine jeweils direkte Beschallung des Substrats mit auf das Substrat gerichtetem Schall vorzusehen oder eine indirekte Beschallung.

Gelöst wird die oben genannte Aufgabe des weiteren durch eine Vorrichtung mit den Merkmalen des Anspruchs 5. Insbesondere ist sie zur Durchführung des vorbeschriebenen Verfahrens geeignet und ausgebildet. Es ist dabei ein Schallgeber vorgesehen zur Beschallung des Substrats und/oder des Bades.

Es ist möglich, den Schallgeber oder eine Membran für den Schallgeber gegenüber der Behandlungsflüssigkeit mit einem positiven Potential zu versehen.

Es kann bei einer derartigen Vorrichtung vorgesehen sein, dass die Substrate flächig sind und horizontal liegend durch das Bad transportiert werden bzw. darin behandelt werden. Vorteilhaft wird der wenigstens eine Schallgeber der erfindungsgemäßen Vorrichtung unterhalb des Substrats angeordnet, da hier vor allem der Großteil der Benetzung mit Behandlungsflüssigkeit stattfindet. Während des Transports, der kontinuierlich oder in Schritten erfolgen kann, ist es möglich, die Substrate zu beschichten und gleichzeitig mit Schall zu beaufschlagen.

### Kurzbeschreibung der Zeichnungen

Zwei Beispiele sind in den Zeichnungen schematisch dargestellt und werden im folgenden näher erläutert. In den Zeichnungen zeigen:
- Fig. 1: einen Schnitt durch eine Beschichtungsvorrichtung mit direkt im Beschichtungsbad angeordneten Schallgebern, wobei diese Ausführungsform nicht zur beanspruchten Erfindung gehört, und
- Fig. 2: eine ähnliche Beschichtungsvorrichtung gemäß der Erfin- dung, wobei die Schallgeber außerhalb des Beschichtungs- bades angeordnet sind und über Kopplereinrichtungen wir- ken.

### Detaillierte Beschreibung der Ausführungsbeispiele

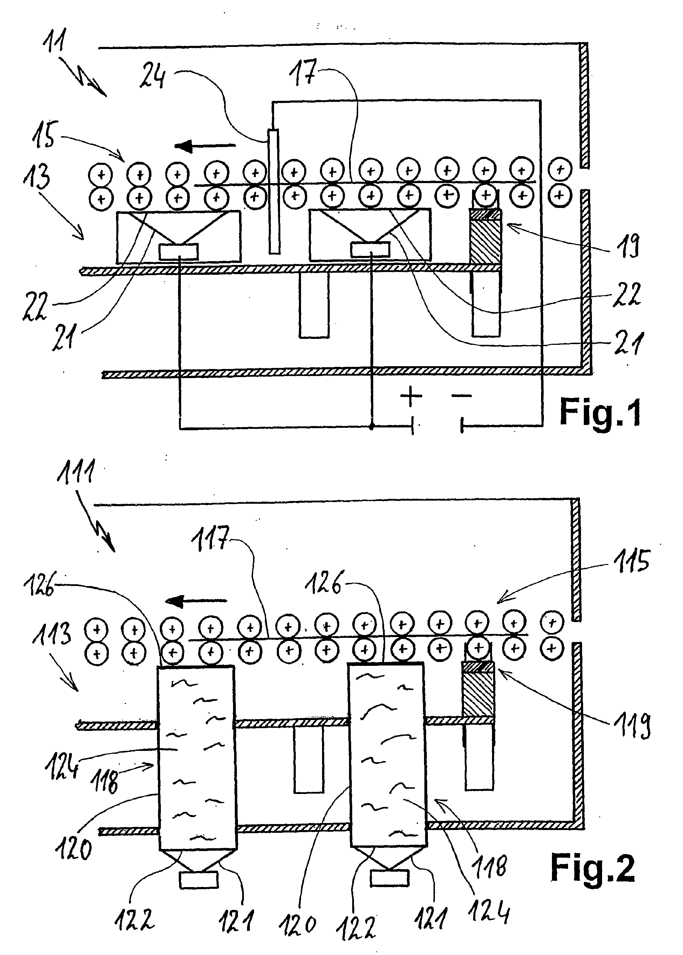

Figur 1 zeigt eine Beschichtungsvorrichtung 11, die nicht zur beanspruchten Erfindung gehört. Die Beschichtungsvorrichtung 11 weist ein Gehäuse 12 auf, in welchem ein abgetrenntes Beschichtungsbad 13 angeordnet ist. In und über dem Beschichtungsbad 13 sind Transportrollen 15 angeordnet, mittels derer eine horizontal liegende Leiterplatte 17 in Pfeilrichtung durch das Beschichtungsbad 13 transportiert wird.

Das Beschichtungsbad 13 ist beispielsweise zur Abscheidung von chemischem Kupfer aus flüssigem Elektrolyten auf der Oberfläche der Leiterplatte 17 ausgebildet. Alternativ dazu kann die Erfindung bei beliebigen Beschichtungsvorgängen mit Behandlungsflüssigkeiten oder nasschemischen Beschichtungen eingesetzt werden. Es ist möglich, was im Rahmen der vorliegenden Erfindung jedoch nur eine untergeordnete Rolle spielt, dass eine Einrichtung zur Erzeugung eines Schwalls der Behandlungsflüssigkeit in dem Beschichtungsbad 13 vorgesehen ist. Damit kann eine besonders gute Benetzung oder Erreichbarkeit der Oberfläche der Leiterplatte, insbesondere im Bereich von dünnen Bohrungen, erreicht werden.

Nach rechts weist das Bad 13 eine Abdichtung 19 auf. Diese ist an sich bekannt und braucht hier nicht näher erläutert zu werden.

Unterhalb der Transportrollen 15 sind zwei Schallgeber 21 angeordnet. Ihre Arbeitsrichtung bzw. Wirkrichtung ist nach oben. Die Schallgeber 21 weisen oben Membranen 22 auf. Die Schallgeber 21 können beispielsweise nach Art von Lautsprechern oder dergleichen ausgebildet sein. Insbesondere können sie für die vorgesehenen Frequenzen spezialisiert sein, also beispielsweise für Ultraschall.

Durch die Beschallung der Leiterplatte 17 können Gasblasen oder dergleichen aus der Behandlungsflüssigkeit des Beschichtungsbades 13 getrieben werden. Des weiteren können lokale Strömungen der Behandlungsflüssigkeit an der Leiterplattenoberfläche erzeugt werden. Auch diese begünstigen eine Beschichtung, insbesondere hinsichtlich der Beschichtungsgeschwindigkeit.

Alternativ zu einer dargestellten Anordnung der Schallgeber 21 unterhalb der Transportrollen 15 bzw. der Leiterplatte 17 ist es selbstverständlich möglich, Schallgeber alternativ oder zusätzlich oberhalb der Leiterplatte 17 vorzusehen. Dies kann auch davon abhängig gemacht werden, an welchem Bereich der Leiterplatte 17 eine Beschichtung stattfinden soll oder an welchem Bereich besonders schwierige Oberflächenkonstellationen der Leiterplatte gegeben sind.

Um beispielsweise eine metallische Membran 22 zur Übertragung des Schalls vom Schallgeber 21 auf die Leiterplatte 17 bzw. das Beschichtungsbad 13 verwenden zu können, wird der Schallgeber 21 bzw. die Membran 22 potentiostatisch oder galvanostatisch geschützt. Hierzu ist zum einen ein Potentiostat 24 vorgesehen, welcher in das Beschichtungsbad 13 reicht. Er ist, wie dargestellt ist, gegenüber den Schallgebern 21 oder den Membranen 22 negativ geladen. So wird eine Abscheidung, beispielsweise von chemischem Kupfer aus einem Elektrolyten, an dem Schallgeber 21 oder der Membran 22 vermieden. Des weiteren ist es möglich, einen Schallgeber oder seine in dem Beschichtungsbad 13 befindliche Membran aus Kunststoff auszubilden. Dies dient dann dazu, dass eine Beschichtung der Membran 22 nicht stattfinden kann.

Bei der alternativen Ausbildung nach Figur 2 sind anstelle der Schallgeber 21 Kopplereinrichtungen 118 vorgesehen, welche von unten gegen die Leiterplatten 117 gerichtet sind. Die Kopplereinrichtungen 118 weisen einen gehäuseartigen Kanal 120 auf. Von unten sind an dem Kanal 120 Schallgeber 121 mit einer eine Begrenzung des Kanals bildenden Membran 122 vorgesehen. Der Kanal 120 ist mit einer Kopplerflüssigkeit 124 gefüllt. An der Oberseite ist der Kanal 120 mit einer Kopplermembran 126 versehen. Die Kopplerflüssigkeit 124 füllt den Kanal 120 vollständig bzw. reicht direkt von der Membran 122 des Schallgebers 121 bis zur Kopplermembran 126.

Bei einem Aktivieren des Schallgebers 121 mit Ultraschall überträgt die Membran 122 die Schallwellen bzw. Schwingungen auf die Kopplerflüssigkeit 124. Diese überträgt sie nahezu verlustfrei an die Kopplermembran 126, welche wiederum in das Beschichtungsbad 113 hineinwirkt bzw. gegen die Unterseite der Leiterplatte 117 wirkt.

Mit einer Beschichtungsvorrichtung 111 gemäß Figur 2 bzw. einer Kopplereinrichtung 118 ist es möglich, ohne Potentiostat 24 gemäß Figur 1 einen Schallgeber 121 mit einer metallischen Membran 122 zu verwenden.

Anstelle von Schallgebern mit Membranen können auch beispielsweise piezoelektrische Schwinger oder dergleichen verwendet werden.

## Patentansprüche

1. Verfahren zur Beschichtung eines Substrats mit einem in einer Behandlungsflüssigkeit gelösten Material, wobei das Substrat zumindest teilweise mit der Behandlungsflüssigkeit in oder über einem Bad (113) benetzt wird, wobei das Bad mit der Behandlungsflüssigkeit und/oder das Substrat mit Schall beaufschlagt werden durch eine indirekte Beaufschlagung des Substrats (117) und/oder des Bades (113) mit Schall, wobei der Schallgeber (121) außerhalb des Bades angeordnet ist, **dadurch gekennzeichnet, dass** eine Ankopplung des Schalls in das Bad über eine Kopplerflüssigkeit (124) mit einer im Bad installierten Membran (126) erfolgt, wobei die Kopplerflüssigkeit (124) einen Kanal (120) füllt, der mit der Membran (126) versehen ist, um in das Bad hineinzuwirken, wobei die Kopplerflüssigkeit (124) von dem Schallgeber (121) bis zur Membran (126) reicht.

2. Verfahren nach Anspruch 1, **dadurch gekennzeichnet, dass** die Beaufschlagung mit Ultraschall erfolgt.

3. Verfahren nach einem der vorhergehenden Ansprüche, **gekennzeichnet durch** eine Beaufschlagung mit Schall an mehreren Stellen mit mehreren Schallgebern (121).

4. Verfahren nach einem der vorhergehenden Ansprüche, **gekennzeichnet durch** einen Transport der Substrate (117) horizontal liegend **durch** das Bad (113) sowie **durch** Beschichtung und Beaufschlagung mit Schall während des Transports.

5. Vorrichtung zur Beschichtung eines Substrats mit einem in einer Behandlungsflüssigkeit gelösten Material zur Durchführung des Verfahrens nach einem der vorhergehenden Ansprüche, wobei das Substrat (117) zumindest teilweise mit der Behandlungsflüssigkeit in oder über einem Bad (113) benetzt ist, mit mindestens einem Schallgeber (121) zur Beaufschlagung des Substrats und/oder des Bads mit Schall, wobei der Schallgeber (121) außerhalb des Bades (113) angeordnet ist, **dadurch gekennzeichnet, dass** eine Ankopplung des Schalls über eine Kopplerflüssigkeit (124) an das Bad (113) mit einer im Bad installierten Membran (126) vorgesehen ist, wobei die Kopplerflüssigkeit (124) einen Kanal (120) füllt, der mit der Membran (126) versehen ist, um in das Bad hineinzuwirken, wobei die Kopplerflüssigkeit (124) von dem Schallgeber (121) bis zur Membran (126) reicht.

6. Vorrichtung nach Anspruch 5, **dadurch gekennzeichnet, dass** der Schallgeber (121) aus Kunststoff gefertigt ist.

7. Vorrichtung nach einem der Ansprüche 5 oder 6, **dadurch gekennzeichnet, dass** die Substrate (117) flächig sind und horizontal liegend in dem Bad (113) sind, wobei der wenigstens eine Schallgeber (121) unterhalb eines Substrates angeordnet ist.

## Claims

1. A method for coating a substrate using a material dissolved in a treatment liquor, the substrate is at least partially wetted by the treatment liquor in or above a bath (113), at least one of the bath including the treatment liquor and the substrate is sonified by indirect sonification of at least one of the substrate (117) and the bath (113), with an external sound generator (121) disposed at the bath, **characterized in that** a coupling of the sound into the bath is provided via a coupling fluid (124) using a membrane (126) installed within the bath, wherein the coupling fluid (124) fills a duct (120) furnished with the membrane (126) to act into the bath, wherein the coupling fluid (124) extends from the sound generator (121) to the membrane (126).

2. The method according to claim 1, **characterized in that** the sonification is an ultrasound sonification.

3. The method according to any of the preceding claims, **characterized in that** sonification is performed at multiple positions using multiple sound generators (121).

4. The method according to any of the preceding claims, **characterized by** carrying the substrates (117) in a horizontal position through the bath (113) as well as coating and sonification during carrying.

5. A device for coating a substrate using a material dissolved in a treatment liquor to perform the method according to any of the preceding claims, wherein the substrate (117) is at least partially wetted by the treatment liquor in or above a bath (113), at least one sound generator (121) is provided for sonification of at least one of the substrate and the bath, the sound generator (121) being disposed externally at the bath (113), **characterized in that** a coupling of the sound to the bath (113) is provided via a coupling fluid (124) using a membrane (126) installed within the bath, wherein the coupling fluid (124) fills a duct (120) furnished with the membrane (126) to act into the bath, wherein the coupling fluid (124) extends from the sound generator (121) to the membrane (126).

6. The device according to claim 5, **characterized in that** the sound generator (121) is made of plastics.

7. The device according to claim 5 or 6, **characterized in that** the substrates (117) are laminar and are in a horizontal position in the bath (113), and the at least one sound generator (121) is disposed below a substrate.

## Revendications

1. Procédé pour revêtir un substrat avec un matériau en solution dans un liquide de traitement, sachant que le substrat est mouillé au moins en partie avec le liquide de traitement dans ou au-dessus d'un bain (113), sachant que le bain avec le liquide de traitement et/ou le substrat sont exposés à des sons par une exposition indirecte du substrat (117) et/ou du bain (113) à des sons, sachant que le générateur de sons (121) est disposé à l'extérieur du bain, **caractérisé en ce qu'**un couplage acoustique au bain est effectué à travers un agent de couplage liquide (124) avec une membrane (126) installée dans le bain, sachant que l'agent de couplage liquide (124) remplit un conduit (120), qui est muni de la membrane (126) pour agir dans le bain, sachant que l'agent de couplage liquide (124) s'étend du générateur de sons (121) jusqu'à la membrane (126).

2. Procédé d'après la revendication 1, **caractérisé en ce que** l'exposition est effectuée avec des ultrasons.

3. Procédé d'après une des revendications précédentes, **caractérisé par** une exposition acoustique à plusieurs endroits au moyen de plusieurs générateurs de sons (121).

4. Procédé d'après une des revendications précédentes, **caractérisé par** un transport des substrats (117) en position horizontale à travers le bain (113) ainsi que par un revêtement et une exposition à des sons pendant le transport.

5. Dispositif pour le revêtement d'un substrat avec un matériau en solution dans un liquide de traitement afin de mettre en pratique le procédé d'après une des revendications précédentes, sachant que le substrat (117) est mouillé au moins en partie avec le liquide de traitement dans ou au-dessus d'un bain (113), avec au moins un générateur de sons (121) pour exposer le substrat et/ou le bain à des sons, sachant que le générateur de sons (121) est disposé à l'extérieur du bain (113), **caractérisé en ce que** le couplage acoustique au bain (113) est prévu à travers un agent de couplage liquide (124) avec une membrane (126) installée dans le bain, sachant que l'agent de couplage liquide (124) remplit un conduit (120), qui est muni de la membrane (126) pour agir dans le bain, sachant que l'agent de couplage liquide (124) s'étend du générateur de sons (121) jusqu'à la membrane (126).

6. Dispositif d'après la revendication 5, **caractérisé en ce que** le générateur de sons (121) est réalisé en matière plastique.

7. Dispositif d'après une des revendications 5 ou 6, **caractérisé en ce que** les substrats (117) sont plats et qu'ils se trouvent en position horizontale dans le bain (113), sachant que le ou les générateurs de sons (121) sont disposés au-dessous d'un substrat.
